## Europäisches Patentamt
## European Patent Office
## Office européen des brevets

(11) Veröffentlichungsnummer: **0 157 924**
**B1**

(12) # EUROPÄISCHE PATENTSCHRIFT

(45) Veröffentlichungstag der Patentschrift:
**04.11.87**

(51) Int. Cl.⁴: **G 01 N 24/06,** A 61 B 5/05

(21) Anmeldenummer: **84115067.5**

(22) Anmeldetag: **10.12.84**

(54) **Hochfrequenz-Antenneneinrichtung in einer Kernspintomographie-Apparatur und Verfahren zu ihrem Betrieb.**

(30) Priorität: **20.03.84 DE 3410215**

(43) Veröffentlichungstag der Anmeldung:
**16.10.85 Patentblatt 85/42**

(45) Bekanntmachung des Hinweises auf die Patenterteilung:
**04.11.87 Patentblatt 87/45**

(84) Benannte Vertragsstaaten:
**DE FR GB**

(56) Entgegenhaltungen:
**EP-A-0 073 375**
**EP-A-0 084 946**
**DE-A-3 133 432**
**DE-C-1 010 595**

**TASCHENBUCH DER HOCHFREQUENZTECHNIK H. MEINKE et al. SPRINGER-VERLAG, 1968, Seite 464**

(73) Patentinhaber: **Siemens Aktiengesellschaft Berlin und München, Wittelsbacherplatz 2, D-8000 München 2 (DE)**

(72) Erfinder: **Krause, Norbert, Dr., Weinbergstrasse 29, D-8551 Heroldsbach (DE)**

## Beschreibung

Die Erfindung bezieht sich auf eine Antenneneinrichtung zur Anregung eines zumindest weitgehend homogenen magnetischen Hochfrequenzfeldes und/oder zum Empfang von entsprechenden hochfrequenten Signalen in einer Kernspintomographie-Apparatur mit einem rohrförmig gestalteten Antennenteil dessen Zylinderachse in Richtung der z-Achse eines rechtwinkligen x-y-z Koordinatensystems orientiert ist, das zumindest weitgehend niederfrequenzdurchlässig für magnetische Gradientenfelder ausgebildet ist, aus einem elektrisch gut leitenden, nicht-magnetischen Material vorbestimmter Dicke besteht und mit einer externen Energieeinspeisungs- bzw. Empfangsvorrichtung verbunden ist. Eine derartige Antenneneinrichtung geht aus der DE-A-31 33 432 hervor. Die Erfindung betrifft ferner ein Verfahren zum Betrieb der Antenneneinrichtung.

Auf dem Gebiet der medizinischen Diagnostik sind bildgebende Verfahren entwickelt worden, bei denen rechnerisch oder meßtechnisch integrale Resonanzsignale von Kernen eines bestimmten Elementes eines zu untersuchenden, insbesondere menschlichen Körpers oder Körperteiles analysiert werden. Aus der so zu gewinnenden räumlichen Spindichte- und/oder Relaxationszeitverteilung läßt sich dann ein Bild ähnlich einem Röntgentomogramm konstruieren. Entsprechende Verfahren sind unter der Bezeichnung "Kernspintomographie" (Nuclear Magnetic Resonance Tomography) oder "Zeugmatographie" bekannt.

Voraussetzung zur Kernspintomographie ist ein von einem sogenannten Grundfeldmagneten erzeugtes starkes Magnetfeld, das in einem Bereich vorbestimmter Ausdehnung möglichst homogen ist und in das der zu untersuchende Körper längs einer Achse, die im allgemeinen mit der Orientierungsachse des magnetischen Grundfeldes übereinstimmt, eingebracht wird. Dieses Grundfeld ist von stationären und/oder gepulsten, sogenannten Gradientenfeldern überlagert. Zur Anregung der einzelnen Atomkerne in dem Körper zu einer Präzessionsbewegung ist außerdem eine besondere Antenneneinrichtung erforderlich, mit der kurzzeitig ein hochfrequentes magnetisches Wechselfeld (HF-Wechselfeld) angeregt werden und die auch zum Empfang der damit verbundenen HF-Signale dienen kann, falls hierfür keine besondere Meßspule vorgesehen wird.

Bei einer solchen Apparatur zur Kernspintomographie (NMR-Tomography) hängt bekanntlich die Qualität der Schnittbilder von dem Signal-Rausch-Verhältnis des induzierten Kernspinresonanzsignals ab. Da dieses Signal-Rausch-Verhältnis seinerseits von der Stärke des magnetischen Grundfeldes abhängt und mit der Frequenz steigt, ist man bestrebt, bei hohen Grundfeldern möglichst hohe Frequenzen vorzusehen (vgl. "Jour. Phys. E: Sci. Instrum.", vol. 13, 1980, Seiten 38 bis 44).

Mit der aus der eingangs genannten DE-A-3 133 432 bekannten HF-Antenneneinrichtung können HF-Felder mit hohen Frequenzen von etwa 20 MHz oder mehr angeregt bzw. empfangen werden. Hierzu enthält die Antenneneinrichtung ein rohrförmiges Antennenteil aus elektrisch gut leitendem, nichtmagnetischem Material. Dieses Antennenteil stellt eine Hülle um mehrere, mindestens ein Leiterpaar bildende Leiterstücke dar, die auf einer gedachten Zylinderfläche liegen, um welche die Hülle konzentrisch in vorbestimmtem Abstand angeordnet ist. Auf dem mindestens einen Leiterpaar und der Hülle wird dann eine Wellenausbreitung mit sehr hoher Frequenz ermöglicht, wobei Resonanzverhältnisse eingestellt werden, so daß im gesamten interessierenden Volumen gleichphasig schwingende Felder in Form von auf dem Leiterpaar stehenden Wellen ausgebildet werden. Da ferner die gemeinsame Hülle um das Leiterpaar so ausgeführt ist, daß sie zumindest weitgehend niederfrequenzdurchlässig ist können sich in dem Volumen, in das der zu untersuchende Körper einzubringen ist, die niederfrequenten Gradientenfelder entsprechend ungehindert ausbreiten.

Aufgabe der vorliegenden Erfindung ist es, diese bekannte Antenneneinrichtung gemäß der eingangs genannten Art zu vereinfachen.

Diese Aufgabe wird erfindungsgemäß dadurch gelöst, daß lediglich das rohrförmige Antennenteil als Rundhohlleiter zur Anregung bzw. zum Empfang des Hochfrequenzfeldes vorgesehen ist, wobei der Rundhohlleiter zumindest im Bereich der durch die Mitte seiner axialen Ausdehnung sich erstreckenden Querschnittsebene mit einem System von Koppelelementen zum Ein- bzw. Auskoppeln der entsprechenden Hochfrequenzleistung versehen ist.

Die mit dieser Ausgestaltung der Antenneneinrichtung verbundenen Vorteile sind insbesondere darin zu sehen, daß mit einem derartigen Rundhohlleiter HF-Felder mit Frequenzen weit über 20 MHz auf verhältnismäßig einfache Weise angeregt bzw. empfangen werden können.

Ein Verfahren zum Betrieb der Antenneneinrichtung, die in mindestens zwei zu der mittleren Querschnittsebene symmetrischen, parallelen Querschnittsebenen jeweils ein weiteres Koppelsystem enthält, ist erfindungsgemäß dadurch gekennzeichnet, daß die Phasen- und Amplitudenverhältnisse an den einzelnen Koppelsystemen mittels der an sie angeschlossenen Energieeinspeisungsvorrichtung derart eingestellt werden, daß die von diesen Koppelsystemen jeweils hervorgerufenen Feldstärken sich zu einer Gesamtfäldstärke überlagern, die außerhalb des durch die parallelen Querschnittsebenen der beiden äußeren, zu der mittleren Querschnittsebene symmetrisch angeordneten Koppelsysteme begrenzten Bereiches praktisch null ist.

Vorteilhafte Ausgestaltungen der Hochfrequenz-Antenneneinrichtung nach der Erfindung gehen aus den abhängigen Ansprüchen 2-7 hervor.

Zur weiteren Erläuterung der Erfindung wird nachfolgend aauf die Zeichnung Bezug genommen, in deren Fig. 1 und 2 eine Hochfrequenz-Antenneneinrichtung nach der Erfindung schematisch angedeutet ist. Die Figuren 3 und 4 zeigen als Diagramme mit dieser Antenneneinrichtung auszubildende Feldstärkeverhältnisse.

Bei der Kernspintomographie-Apparatur, für welche die Hochfrequenz-Antenneneinrichtung nach der Erfindung vorzusehen ist, wird von bekannten Apparaturen zur Kernspintomographie ausgegangen. Eine entsprechende Apparatur ist z. B. in der EP-A-21 535 A1 oder in der DE-A-28 40 178 angedeutet. Sie weist im allgemeinen mindestens ein bezüglich der z-Achse eines x-y-z-Koordinatensystems konzentrisch angeordnetes normal- oder insbesondere supraleitendes Feldspulensystem auf, mit dem ein starkes, möglichst homogenes Grundfeld in z-Richtung erzeugt wird. Außerdem sind Gradientenspulen zur Erzeugung hinreichend konstanter magnetischer Feldgradienten vorgesehen. Die Magnetspulen erlauben einen axialen Zugang zum homogenen Feldbereich in ihrem Zentrum, d. h. der zu untersuchende, insbesondere menschliche Körper oder Körperteil wird längs der z-Achse in das Magnetfeld eingebracht. Die Anregung der Kernspins erfolgt mittels eines senkrecht zur z-Achse gerichteten, möglichst homogenen Hochfrequenzfeldes.

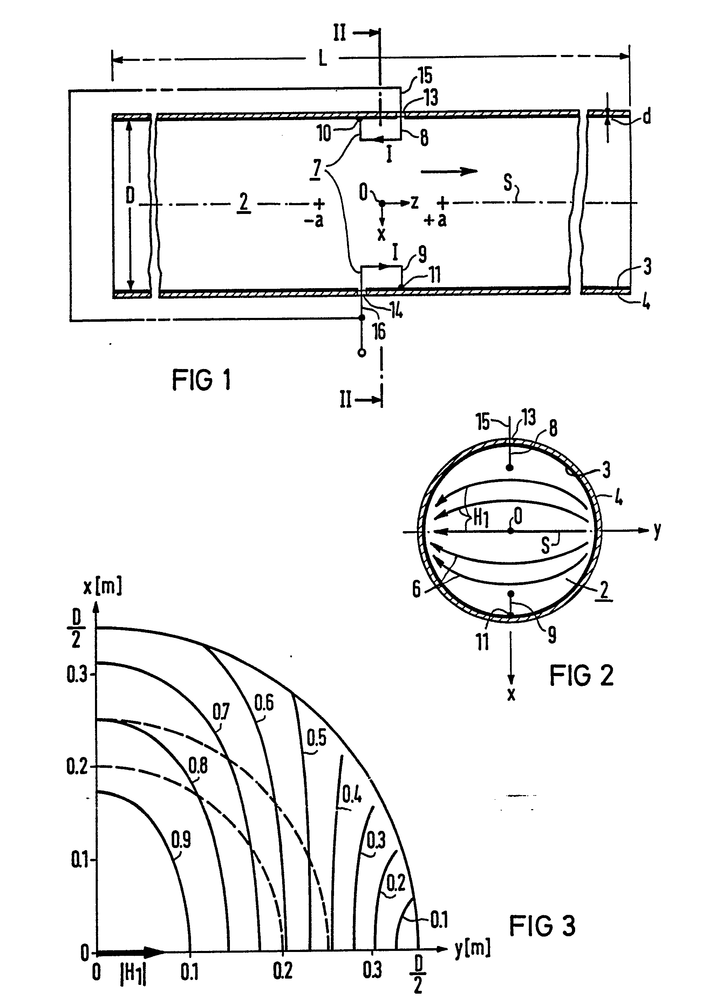

Ein Ausführungsbeispiel einer hierfür zu verwendenden Hochfrequenz-Antenneneinrichtung nach der Erfindung ist in Fig. 1 als Längsschnitt bzw. in Fig. 2 als Querschnitt angedeutet. Dabei sind gleiche Bauteile mit den gleichen Bezugszeichen versehen. Die Antenneneinrichtung enthält einen hohlzylindrischen Rundhohlleiter 2, dessen Zylinderachse in Richtung der z-Achse eines rechtwinkligen x-y-z-Koordinatensystems orientiert ist. Der Koordinatenursprung 0 ist dabei in die axiale Mitte des Rundhohlleiters gelegt. Dieser Rundhohlleiter mit einer axialen Länge L und einem Durchmesser D besteht aus einem elektrisch gut leitenden, nicht-magnetischen Material wie z. B. aus Kupfer und kann gegebenenfalls zumindest auf einer Seite versilbert sein. Beispielsweise wird der Rundhohlleiter 2 von einem nichtmetallischen, elektrisch isolierenden rohrförmigen Träger gebildet, auf dessen Außen- oder Innenseite eine dünne Kupferfolie oder -schicht aufgebracht ist. Gemäß dem in den Fig. 1 und 2 angenommenen Ausführungsbeispiel wird die eigentliche Antenne durch eine Kupferfolie 3 mit einem Durchmesser D auf der Innenseite eines Trägerrohres 4 gebildet. Da der Rundhohlleiter ausreichend durchlässig für die niederfrequenten Gradientenfelder sein soll, muß einerseits die Wanddicke d seines elektrisch leitenden Materials verhältnismäßig gering sein. Andererseits wird aber mit abnehmender Dicke der HF-Widerstand des Hohlleiters erhöht, weshalb die Dicke d vorteilhaft größer als die Eindringtiefe des hochfrequenten Feldes gewählt werden sollte. Im allgemeinen liegt die Dicke d zwischen 10 μm und 50 μm.

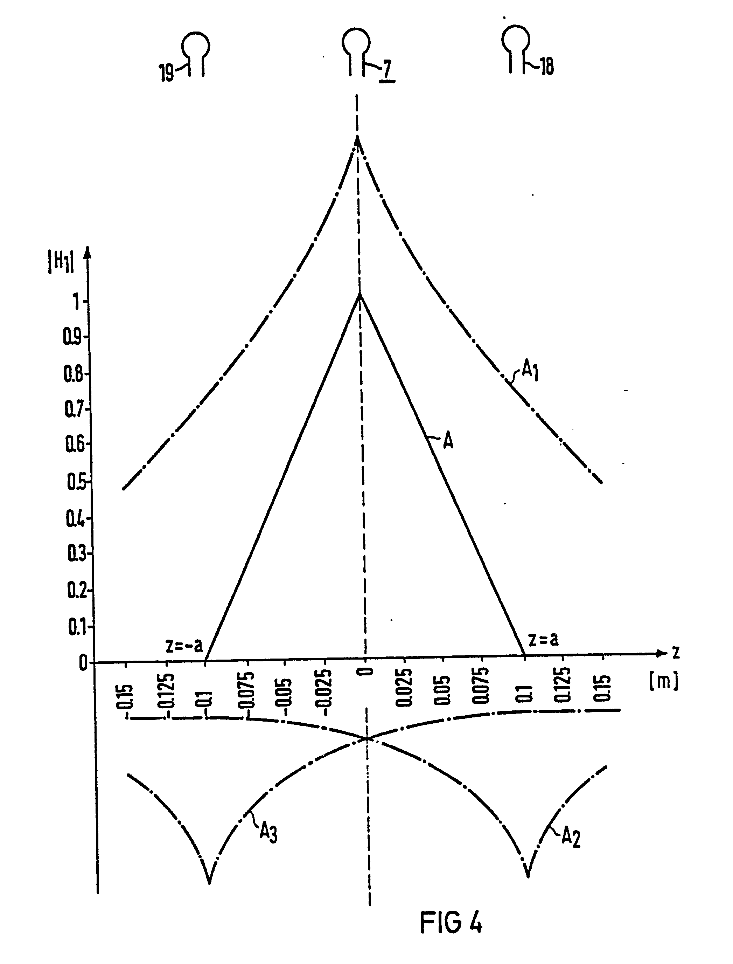

Mit diesem Rundhohlleiter 2 wird erfindungsgemäß ein durch gestrichelte, gepfeilte Linien 6 angedeutetes hochfrequentes Magnetfeld $H_1$ erzeugt, das zumindest in dem zentralen Untersuchungsbereich um den Koordinatenursprung (z = 0) weitgehend homogen und senkrecht zur z-Achse gerichtet ist. Hierzu wird von einer in der Figur nicht dargestellten Energieeinspeisungsvorrichtung über ein zumindest im Bereich der durch den Koordinatenursprung (z = 0) verlaufenden Querschnittsebene an dem Rundhohlleiter 2 angebrachtes System 7 von Koppelelementen die hochfrequente Energie bzw. Leistung in den Hohlleiter 2 eingespeist. Das Koppelsystem 7 besteht aus mindestens einem Paar von Koppelelementen 8 und 9, die diametral zueinander, symmetrisch zu der durch den Koordinatenursprung 0 sich erstreckenden y-z-Ebene S angeordnet sind. Diese an sich bekannten Koppelelemente sind auf der Innenseite des Hohlleiters 2 bügelförmig, sich in z-Richtung erstreckend gestaltet und einseitig an die elektrisch leitenden Hohlleiterwand 3 an Stellen 10 bzw. 11 angeschlossen (vgl. z. B. H. Meinke/F. W. Grundlach: Taschenbuch der Hochfrequenztechnik, 3. Auflage, 1968, Seiten 462 bis 465, insbesondere Abb. 4.4). Ihr anderes Ende ist isoliert durch die Hohlleiterwand 3, 4 an Stellen 13 und 14 hindurchgeführt und über Koaxialkabel 15 und 16 mit der externen Energieeinspeisungsvorrichtung verbunden. Die Anschlüsse 10 und 11 und damit auch die Durchführungen 13 und 14 sind dabei so angeordnet, daß die durch Pfeile an den Leiterbügeln angedeuteten Flußrichtungen der Ströme I in den gegenüberliegenden Koppelelementen in z-Richtung gesehen entgegengesetzt sind.

Gemäß dem in den Fig. 1 und 2 gezeigten Ausführungsbeispiel weist das Koppelsystem 7 nur zwei Koppelelemente 8 und 9 auf. Gegebenenfalls kann das System aber auch auf jeder Seite der y-z-Symmetrieebene S nicht aus einem, sondern aus mehreren, gleichsinnig stromdurchflossenen Koppelelementen gebildet sein, so daß dann eine entsprechende Anzahl von Paaren gegensinnig stromdurchflossener, diametral angeordneter Koppelelemente vorgesehen sind.

Da der Durchmesser D des Rundhohlleiters 2 im Verhältnis zur Wellenlänge des hochfrequenten Feldes mit 20 MHz oder höher klein ist, kann der Rundhohlleiter in einem sogenannten "CUT-OFF"-Bereich unterhalb einer bestimmten Grenzfrequenz betrieben werden. Hierbei handelt es sich um einen Bereich aperiodischer Wellenausbreitung (vgl. das genannte Taschenbuch, Seiten 313 bis 316). Koppelt man also in der Ebene z = 0 des sich von z = $-\frac{1}{2}$ bis z = $\frac{1}{2}$ erstreckenden Hohlleiters eine hochfrequente Leistung ein, so fällt das magnetische HF-Feld gemäß einer Funktion exp (- $\alpha|z|$) nach positivem und negativem z hin ab (vgl. das genannte Taschenbuch, Seite 309). $\alpha$ ist dabei ein für den Feldzustand, den sogenannten Mode, im Hohlleiter typischer, frequenzabhängiger Zahlenwert. Besonders günstig für eine Anwendung in der Kernspintomographie ist ein Betrieb in dem sogannten $H_{11}$-Mode mit einem zur z-Achse transversalen magnetischen Feld $H_{11}$ (vgl. z. B. das genannte Taschenbuch, Seiten 332 bis 334). In dem in Fig. 3 gezeigten Diagramm ist eine solche Transversalebene xy mit Linien konstanter relativer Feldstärke vom Betrage $|H_1|$ gezeigt. Dabei wurden ein Durchmesser D von 0,7 m und eine Frequenz f von 64 MHz angenommen. Die im Zentrum (x = y = 0) ausgebildete, in y-Richtung weisende Feldstärke soll dabei einen normierten Betrag $|H_1|$ = 1 haben. Die sich damit ergebenden Feldstärken sind an den einzelnen Linien eingetragen. Ferner sind gestrichelt Meßvolumina von 0,4 m bzw. 0,5 m Durchmesser eingezeichnet, die für Apparaturen zur Kernspintomographie von besonderem Interesse sind.

Gemäß dem Ausführungsbeispiel nach den Figuren 1 und 2 wurde davon ausgegangen, daß eine Anregung der Rundhohlleiterantenne nur in der transversalen Mittelebene (z = 0) über ein entsprechendes aus den einzelnen Koppelelementen gebildetes Koppelsystem erfolgt. Besonders vorteilhaft ist es jedoch, wenn man in mehreren transversalen Ebenen anregt, wobei in jeweils symmetrisch zu der transversalen Mittelebene (z = 0) liegenden transversalen Ebenen entsprechende Koppelsysteme vorgesehen werden. So kann man insbesondere in drei transversalen Ebenen über beispielsweise dem Koppelsystem 7 gemäß Fig. 1 entsprechende Koppelsysteme anregen. Dem in Fig. 4 gezeigten Diagramm ist eine entsprechende Anregung zugrundegelegt. In diesem Diagramm ist der Betrag der relativen Feldstärke $|H_1|$ in Längsrichtung des Hohlleiters in Abhängigkeit von der Ortslage auf der z-Achse angegeben. Die drei durch jeweils ein symbolisches Koppelelement angedeuteten Koppelsysteme 7, 18 und 19 sollen dabei bei z = 0 (System 7), bei z = a = 0,1 m (System 18) und -a = -0,1 m (System 19) angeordnet sein. Auf der Ordinate ist dabei der Betrag von $|H_1|$ in relativen Einheiten bezüglich des für z = 0 zu 1 normierten Wertes angegeben. Wird dann in die einzelnen Koppelsysteme mit einem definierten Phasen- und Amplitudenunterschied eingespeist, so läßt sich ein nahezu linearer Feldabfall von z = 0 nach rechts und links einstellen. Dieser durch die durchgezogene Kurve A dargestellte Feldverlauf ergibt sich aus einer Überlagerung der von den einzelnen Koppelsystemen erzeugten Feldformen. Der allein von dem Koppelsystem 7 hervorgerufene Feldverlauf ist durch eine mit $A_1$ bezeichnete, strichpunktierte Kurve, der von dem Koppelsystem 18 hervorgerufene Feldverlauf durch eine strichpunktierte, mit $A_2$ bezeichnete Kurve und der von dem Koppelsystem 19 hervorgerufene Feldverlauf durch eine strichpunktierte, mit $A_3$ bezeichnete Kurve hervorgerufen. Das Feld $H_1$ (Kurve A) ist somit für alle z mit Betrag $|z|$ größer a = 0,1 m praktisch null. D. h., das Feld ist auf eine schmale transversale Schicht begrenzt. Auf diese Weise läßt sich vorteilhaft insbesondere eine Rauscheinkopplung aus nicht ins Meßvolumen fallenden Körperteilen des zu untersuchenden Körpers unterbinden.

**Patentansprüche**

1. Antenneneinrichtung zur Anregung eines zumindest weitgehend homogenen magnetischen Hochfrequenzfeldes und/oder zum Empfang von entsprechenden hochfrequenten Signalen in einer Kernspintomographie-Apparatur mit einem rohrförmig gestalteten Antennenteil (2) dessen Zylinderachse in Richtung der z-Achse eines rechtwinkligen x-y-z Koordinatensystems orientiert ist, das zumindest weitgehend niederfrequenzdurchlässig für magnetische Gradientenfelder ausgebildet ist, aus einem elektrisch gut leitenden, nicht-magnetischen Material vorbestimmter Dicke besteht und mit einer externen Energieeinspeisungs- bzw. Empfangsvorrichtung verbunden ist, dadurch gekennzeichnet, daß lediglich das als Rundhohlleiter ausgebildete rohrförmige Antennenteil (2) zur Anregung bzw. zum Empfang des Hochfrequenzfeldes vorgesehen ist, wobei der Rundhohlleiter (2) zumindest im Bereich der durch die Mitte seiner axialen Ausdehnung (L) sich erstreckenden Querschnittsebene z = 0 mit einem System (7, 18, 19) von Koppelelementen (8, 9) zur Ein- bzw. Auskopplung der entsprechenden Hochfrequenzleistung versehen ist.

2. Antenneneinrichtung nach Anspruch 1, dadurch gekennzeichnet, daß der Rundhohlleiter (2) aus einer Folie (3) oder Schicht besteht, die auf der Innen- oder Außenseite eines aus elektrisch isolierendem Material bestehenden Trägerkörpers (4) aufgebracht ist.

3. Antenneneinrichtung nach Anspruch 1 oder 2, dadurch gekennzeichnet, daß die Dicke (d) des aus elektrisch leitendem Material bestehenden Teils (3) des Rundhohlleiters (2) zwischen 10 µm und 50 µm liegt.

4. Antenneneinrichtung nach einem Ansprüche 1 bis 3, dadurch gekennzeichnet, daß das Koppelsystem (7, 18, 19) mindestens ein Paar von an der Innenseite des Rundhohlleiters (2) angeordneten, sich diametral gegenüberstehenden Koppelelementen (8, 9) aufweist.

5. Antenneneinrichtung nach Anspruch 4, dadurch gekennzeichnet, daß die Koppelelemente (8, 9) bügelförmig gestaltet sind und axial verlaufende Leiterteile aufweisen, die einseitig mit dem elektrisch leitenden Material (3) des Rundhohlleiters (2) elektrisch leitend verbunden sind.

6. Antenneneinrichtung nach Anspruch 5, dadurch gekennzeichnet, daß Verbindungsstellen (10, 11) der bügelförmigen Koppelelemente (8, 9) mit dem Rundhohlleiter (2) angeordnet sind, so daß die Flußrichtungen des Stromes (I) in den axial ausgerichteten Leiterteilen dieser Elemente (8, 9) entgegengesetzt verlaufen.

7. Antenneneinrichtung nach einem der Asprüche 1 bis 6, dadurch gekennzeichnet, daß in mindestens zwei zu der mittleren Querschnittsebene z = 0, symmetrischen, parallelen Querschnittsebenen z = +a bzw. z = -a jeweils ein weiteres Koppelsystem (18 bzw. 19) vorgesehen ist.

8. Verfahren zum Betrieb der Antenneneinrichtung nach Anspruch 7, dadurch gekennzeichnet, daß die Phasen- und Amplitudenverhältnisse an den einzelnen Koppelsystemen (7, 18, 19) mittels der an sie angeschlossenen Energieeinspeisungsvorrichtung derart eingestellt werden, daß die von diesen Koppelsystemen (7, 18, 19) jeweils allein hervorgerufenen Feldstärken ($A_1$ bis $A_3$) sich zu einer Gesamtfeldstärke (A) überlagern, die außerhalb des durch die parallelen Querschnittsebenen z = +a, z = -a der beiden äußeren, zu der mittleren Querschnittsebene z = 0 symmetrisch angeordneten Koppelsysteme (18 bzw. 19) begrenzten Bereiches praktisch null ist.

## Claims

1. An antenna device for exciting an at least substantially homogeneous, magnetic high-frequency field and/or for receiving corresponding high-frequency signals in a nuclear resonance tomography apparatus, comprising a tubular antenna component (2), whose cylindrical axis is orientated in the direction of the z-axis of a rectangular x-y-z coordinate system, which is designed to be at least substantially lowfrequency-transmissive for gradient magnetic fields, which consists of an electrically highly conductive, non-magnetic material of a predetermined thickness, and which is connected to an external energy supply and receiving device, characterised in that only the tubular antenna component (2), in the form of a circular waveguide, serves to exite and receive the high-frequency field, where the circular waveguide (2) is provided with a system (7, 18, 19) of coupling elements (8, 9) for the input coupling and output coupling of the corresponding high frequency power at least in the region of the cross-sectional plane z = 0, which extends through the centre of its axial dimension (L).

2. An antenna device as claimed in Claim 1, characterised in that the circular waveguide (2) consists of a foil (3) or layer applied to the inside or outside of a carrier component (4) of electrically insulating material.

3. An antenna device as claimed in Claims 1 or 2, characterised in that the thickness (d) of that component (3) of the circular waveguide (2) of electrically conductive material is between 10 μm and 50 μm.

4. An antenna device as claimed in Claims 1 to 3, characterised in that a coupling system (7, 18, 19) comprises at least one pair of coupling elements (8, 9) arranged on the inside of the circular waveguide (2) diametrically opposite one another.

5. An antenna device as claimed in Claim 4, characterised in that the coupling elements (8, 9) are yoke-shaped and comprise axially-extending conductor components electrically conductively connected to the electrically conductive material (3) of the circular waveguide (2) on one side.

6. An antenna device as claimed in Claim 5, characterised in that connection points (10, 11) of the yoke-shaped coupling elements (8, 9) to the circular waveguide (2) are arranged such that the flux directions of the current (I) oppose one another in the axially aligned conductor components of these elements (8, 9).

7. An antenna device as claimed in one of Claims 1 to 6, characterised in that a further coupling system (18; 19) is in each case provided in at least two parallel cross-sectional planes z = +a; z = -a; symmetrical to the central cross-sectional plane z = 0.

8. A method of operating the antenna device as claimed in Claim 7, characterised in that the phase and amplitude conditions of the individual coupling systems (7, 18, 19) are set by the energy supply device to which they are connected such that the field strengths ($A_1$ to $A_3$), produced solely by these coupling systems (7, 18, 19), become superimposed to form an ove rall field et rength (A) practically zero outside of the zone delimited by the parallel cross-sectional planes, z = +a and z = -a, of the two outer coupling systems (18; 19) arranged symmetrically in relation to the central cross-sectional 5 plane z = 0.

## Revendications

1. Dispositif d'antenne utilisable pour l'excitation d'un champ magnétique de haute fréquence, au moins dans une large mesure homogène, et/ou pour la réception de signaux correspondant de haute fréquence dans un appareil de tomographie à résonance magnétique nucléaire, comportant un élément d'antenne agencé sous une forme tubulaire, dont l'axe est orienté suivant la direction de l'axe z d'un système de coordonnées rectangulaires x-y-z et qui est réalisé de manière à être au moins dans une large mesure perméable pour les basses fréquences pour des champs magnétiques irrotationnels, qui est constitué en un matériau amagnétique bon conducteur de l'électricité et possédant une épaisseur prédéterminée et qui est relié à un dispositif extérieur d'alimentation ou de réception d'énergie, caractérisé par le fait que seul l'élément d'antenne de forme tubulaire, réalisé sous la forme d'un guide d'ondes circulaire (2) est prévu pour l'excitation ou la réception du champ à haute fréquence, le guide d'ondes circulaire (2) comportant, au moins dans la zone du plan de coupe transversale z = 0, qui passe par la partie médiane de son étendue axiale (L), un système (7, 18, 19) d'organes de couplage (8, 9) servant à injecter par couplage ou extraire par découplage la puissance correspondante à haute fréquence.

2. Dispositif d'antenne suivant la revendication 1, caractérisé par le fait que le guide d'ondes circulaire (2) est constitué par une feuille (3) ou une couche, qui est disposée sur la face intérieure ou la face extérieure d'un corps de support (4) réalisé en un matériau électriquement isolant.

3. Dispositif d'antenne suivant la revendication 1 ou 2, caractérisé par le fait que l'épaisseur (d) de la partie (3), réalisée en un matériau électriquement conducteur, du guide d'ondes circulaire (2) est comprise entre 10 μm et 50 μm.

4. Dispositif d'antenne suivant l'une des revendications 1 à 3, caractérisé par le fait que le système de couplage (7, 18, 19) comporte au moins un couple d'organes de couplage (8, 9) diamétralement opposés, disposés sur la face intérieure du guide d'ondes circulaire (2).

5. Dispositif d'antenne suivant la revendication 4, caractérisé par le fait que les organes de couplage (8, 9) sont réalisés sous la forme d'étriers et possèdent des éléments conducteurs axiaux, qui sont reliés d'une manière électriquement conductrice, d'un côté, au matériau électriquement conducteur (3) du guides d'ondes circulaire (2).

6. Dispositif d'antenne suivant la revendication 5, caractérisé par le fait que des points de liaison (10, 11) des organes de couplage en forme d'étriers (8, 9) au guide d'ondes circulaire (2) sont disposés de telle sorte que les directions du flux du courant (I) s'étendent dans des directions opposées dans les éléments conducteurs axiaux de ces organes (8, 9).

7. Dispositif d'antenne suivant l'une des revendications 1 à 6, caractérisé par le fait qu'un autre système de couplage (18, 19) est prévu respectivement dans au moins deux plans parallèles de coupe transversale z = +a ou z = -a, qui sont symétriques par rapport au plan median de coupe transversale z = 0.

8. Procédé pour la mise en oeuvre du dispositif d'antenne suivant la revendication 7, caractérisé par le fait que les conditions de phase et d'amplitude dans les systèmes individuels de couplage (7, 18, 19) sont réglées au moyen du dispositif d'alimentation en énergie, qui est raccordé à ces systèmes, de telle sorte que les intensités de champ ($A_1$ à $A_3$), qui sont provoquées respectivement uniquement par ces systèmes de couplage (7, 18, 19), se superposent de manière à former une intensité de champ globale (A), qui est pratiquement nulle à l'extérieur de la zone limitée par les plans parallèles de coupe transversale z = +a, z = -a des deux systèmes extérieurs de couplage (18 ou 19) disposés symétriquememt par rapport au plan médian de coupe transversale z = 0.

FIG 1

FIG 2

FIG 3

0 157 924

FIG 4